# EUROPEAN PATENT APPLICATION

(11) **EP 2 552 022 A1**
(43) Date of publication of application: **30.01.2013**
(21) Application number: 11175425.5
(22) Date of filing: 26.07.2011
(51) Int. Cl.: H03K 17/955

(54) **Sensing circuit and method for operating the same**

(71) Applicant: austriamicrosystems AG, 8141 Unterpremstätten (AT)
(72) Inventor: Singnurkar, Pramod, 8052 Graz (AT); Anilloy, Frank, 8052 Graz (AT)
(74) Representative: Epping - Hermann - Fischer

(57) **Abstract**

In one embodiment a sensing circuit comprises a first serial circuit comprising a first and a second capacitor (C1, C2) connected in series, the first serial circuit being connected between a first node (P) and a second node (R), a first transmitter (Tx1) which is coupled to the first node (P) in a switchable manner, a receiver (Rx) which is coupled to the second node (R) in a switchable manner, wherein a first floating electrode (E1) is constituted by the adjacent plates of first and second capacitor (C1, C2), wherein the first floating electrode (E1) is adapted to emit an electric field by means of the first transmitter (Tx1) and to detect a change in capacitance in the emitted electric field caused by an external object, and wherein the receiver (Rx) is adapted to provide an output signal (Vout) as a function of the change in capacitance at the first floating electrode (E1). Furthermore, a method for operating the sensing circuit is described.

## Description

The invention relates to a sensing circuit and to a method for operating the sensing circuit.

In the field of detecting proximity of objects, like human fingers, to devices, for instance portable systems, mobile phones, cordless phones, PDAs, different solutions based on capacitive sensing are employed. An example solution uses a single electrode to emit an electric field and to measure capacitance with respect to ground potential. Thereby, a so-called direct current coupling, DC coupling, occurs between the sensed object and the electrode. This leads to a long response time of a sensor. To reduce the response time, amplifiers with a high bandwidth are implemented in the receiver part of the sensor which in turn increases the cost of a sensor.

It is therefore an objective to provide a circuit and a method which enhance capacitive sensing.

The objective is achieved by the subject-matter of the independent claims. Embodiments and developments of the invention are subject-matter of the dependent claims.

In one embodiment a sensing circuit comprises a first serial circuit being connected between a first node and a second node, a first transmitter which is coupled to the first node in a switchable manner, and a receiver which is coupled to the second node in a switchable manner. The serial circuit comprises a first and a second capacitor connected in series.

Thereby, a first floating electrode is constituted by the adjacent plates of first and second capacitor. The first floating electrode is adapted to emit an electric field by means of the first transmitter and to detect a change in capacitance in the emitted electric field caused by an external object. The receiver is adapted to provide an output signal as a function of the change in capacitance at the first floating electrode.

By coupling the transmitter to the first node, the first floating electrode transmits an electrostatic field. As soon as an external object approaches the first floating electrode, the capacitance of the emitted electric field changes. This change is detected by the first floating electrode and propagated via the second node to the receiver. The receiver provides the output signal as a function of the change in capacitance at the first floating electrode.

As the first floating electrode is isolated from the first transmitter as well as from the receiver by means of the first and second capacitor, a DC coupling between the external object which is sensed and first node or second node is eliminated. Consequently, the response time of the sensing circuit is advantageously reduced. In addition, first transmitter and receiver are always coupled by means of an AC coupling so that the noise gets easily cancelled in the receiver.

A "floating electrode" in this description refers to an electrode with a floating potential. The first transmitter is realized, for example, by a signal generator which is connected to ground potential on the one side and switchably connected to the first node on the other side.

In another exemplary embodiment, the sensing circuit further comprises a second serial circuit connected between the first node and a third node, a second transmitter and another capacitor. The third node is coupled to the receiver in a switchable manner. The second serial circuit comprises a third and a fourth capacitor which are connected in series. The second transmitter is coupled to the third node in a switchable manner. The other capacitor is coupled to the first node and is connected to ground potential. A second floating electrode is constituted by the adjacent plates of third and fourth capacitor. The second floating electrode is adapted to emit an electric field by means of the first or second transmitter and to detect a change in capacitance in the emitted electric field caused by an external object. The receiver is adapted to provide the output signal as a function of the change in capacitance at the second floating electrode or as a function of the change in capacitance between the first and the second floating electrode.

Either the first or the second transmitter is turned on by activating the respective switchable connection to the first node or to the third node. An external object can be detected by separate sensing of the first or the second floating electrode or by common sensing of the first and the second floating electrode. In case the external object is grounded, the proximity of this object can be detected by just one of the floating electrodes. If, on the other hand, the external object is not grounded or ungrounded, its proximity is detected by common sensing of first and second floating electrode.

This embodiment advantageously enables sensing of grounded as well as ungrounded objects.

Ungrounded or partially grounded objects comprise a ground potential which is completely or only periodically isolated from the ground potential of the sensing circuit. Thereby, a huge capacitance builds up between the ground potential of the external object and the ground potential of the sensing circuit. In contrast to this, grounded objects have the same ground potential as the sensing circuit.

The other capacitor represents the capacitance of the first node. When realizing the sensing circuit in CMOS technology, each node would become a pin of the sensing circuit and this node would have a capacitance for protection against electrostatic discharge, ESD. This capacitance is reused in this embodiment of the sensing circuit as other capacitor. The sensing circuit thereby becomes insensitive to the ESD capacitance as the other capacitor is part of the sensing circuit.

A typical use case of this embodiment could be the gripping of a device, for instance, a mobile phone, with human fingers on two sides of the phone. As first and second floating electrodes can be placed on both sides of the phone, the gripping can be detected easily and reliably.

The capacitors are dimensioned such that the capacitance value of the other capacitor is much higher than the capacitance values of the first, second, third and fourth capacitors. As an example, the capacitance of the other capacitor is in the range of picofarad whereas the capacitance value of the first, second, third and fourth capacitor is in the range of femtofarad. Thereby, first, second, third and fourth capacitor need not have the same capacitance values.

In another exemplary embodiment, the sensing circuit comprises a third serial circuit connected between the first node and a fourth node and a third transmitter which is coupled to the second node in a switchable manner. The fourth node is coupled to the receiver in a switchable manner. The third serial circuit comprises a fifth and a sixth capacitor which are connected in series. A third floating electrode is constituted by the adjacent plates of fifth and sixth capacitor. The third floating electrode is adapted to emit an electric field by means of the first, second or third transmitter and to detect a change in capacitance in the emitted electric field caused by an external object. The receiver is adapted to provide the output signal as a function of the change in capacitance at the third floating electrode or as a function of the change in capacitance between the first and the third floating electrode or between the second and third floating electrodes.

With this exemplary embodiment, external objects which are near the first and third floating electrode can be detected. In this case, the first floating electrode is operated as transmitter and the third floating electrode is operated as receiver by activating or deactivating the respective switchable connections. Correspondingly, an external object near the second and third floating electrodes can be detected. In this case, the second floating electrode is configured as transmitter and the third floating electrode is configured as receiver again. For detecting an external object near the first, second and third floating electrodes, two of the floating electrodes are operated as transmitters and one floating electrode is operated as receiver.

In a further exemplary embodiment, the first and/or second and/or third floating electrodes is/are each implemented on a printed circuit board without wired contact to the remaining sensing circuit.

As explained above, the first, second, third and fourth nodes represent the pins of the sensing circuit which can be connected to a chip in which the sensing circuit is used. In this embodiment, the floating electrodes are implemented in such a way that there is no wired contact but only capacitive coupling between the respective nodes and the floating electrodes. This gives more freedom for positioning a floating electrode on the surface of, for instance, a portable device.

In an alternative embodiment, the first and/or second and/or third floating electrode is/are each implemented on a printed circuit board, PCB, with a single wire contact to the remaining sensing circuit.

The remaining sensing circuit comprises all other components of the respective embodiments described above except the capacitors. In this embodiment, for instance the first floating electrode has a single wire contact to the first and second capacitor which also can be implemented with PCB routing.

In another alternative embodiment, the first and/or second and/or third floating electrodes is/are each implemented on a printed circuit board with a double wire contact to the remaining sensing circuit.

In case of the first floating electrode, the first wire connects the second electrode of the first capacitor to the first node. The second wire contacts the second electrode of the second capacitor to the second node.

The three alternatives described above offer different possibilities in designing the sensing electrodes and for placing them on, for example, a portable device.

In yet another embodiment, the receiver comprises an amplifier and an analog-to-digital converter coupled to an output of the amplifier. The amplifier is adapted to receive a signal from at least one of first, second or third floating electrodes. The analog-to-digital converter is adapted to provide the output signal.

The amplifier is, for instance, a trans-impedance amplifier with a programmable gain.

In another exemplary embodiment, one or more of first, second, third, fourth, fifth or sixth capacitors are realized as two separate electrodes.

In another alternative embodiment, one or more of first, second, third, fourth, fifth or sixth capacitors are realized as two separate electrodes wherein one of these electrodes is coupled to ground potential.

This realization can be used for single point button sensing.

In yet another embodiment, the sensing circuit further comprises a comparator element which is connected to the output of the receiver. The comparator element is adapted to indicate whether a value of the output signal is below a lower threshold or above an upper threshold.

The output signal of the receiver is compared in the comparator element with the lower and the upper threshold. A superordinate circuit, in which the sensing circuit is used, is subsequently enabled to react to the detected proximity of an external object.

The comparator element can, for instance, be implemented within a microcontroller which is connected to the receiver.

In one embodiment a method for operating a sensing circuit comprises the following steps:
- performing an initial calibration with identification of an operating point in the linear range of a receiver of the sensing circuit,
- operating in continuous mode, comprising:
   o measuring a value of an output signal of the receiver at the identified operating point in programmable time intervals,
   o if the value is below a lower threshold: generating an interrupt and then continuing with the continuous operation,
   o if the value is above an upper threshold: running through a recalibration and then continuing with the continuous operation.

In the initial calibration the operating point of the sensing circuit is defined. The operating point lies in the linear range of the receiver. After this, the sensing circuit operates in continuous mode. A value of the output signal of the receiver is measured at defined points in time. The value measured is first compared to a lower threshold. A value below this lower threshold signifies the detection of an external object in the proximity of the sensing circuit. Therefore, an interrupt is generated to signal the event to a superordinate circuit. Subsequently, continuous operation is resumed. If the measured value is higher than the lower threshold, it is compared to the upper threshold. If the value is above the upper threshold, the sensing circuit was calibrated with an external object being in the proximity of the sensing circuit. Consequently, a recalibration has to take place to adapt the operating point of the sensing circuit. After this recalibration continuous operation is resumed.

As an advantage, the calibration of the operating point in the linear range of the receiver of the sensing circuit takes place automatically, even if an object to be sensed is already in the vicinity of the sensing circuit. As the values of the initial calibration are double-checked during the continuous operation, a recalibration will be run through in case an object to be sensed was in the vicinity of the sensing circuit during initial calibration that means, for instance, that a mobile phone with the sensing circuit implemented was gripped during initial calibration. A calibration, a parameterization or an initialization by the end user is advantageously not required.

In another exemplary embodiment of the method, the operating point of the receiver is defined by a value of a gain amplifier and a respective sampling point in time of its analog-to-digital converter at a maximum of a signal received by the receiver. The maximum of this signal is related to a transmitted signal phase. The operating point of the receiver is determined during calibration or during recalibration such that a value of the output signal from the receiver at the operating point is as close as possible to a predetermined level within the linear range of the receiver.

In the initial calibration or recalibration the operating point of the receiver is determined by first adjusting the level of the output signal of the analog-to-digital converter. For this level to lie within the linear range of the receiver, it is pre-defined, for example, in the middle of the range of the analog-to-digital converter. Subsequently, various values of the output signal are measured at a first gain value of the amplifier. Measuring is continued until a maximum of the received signal is found in the curve of the measure values. The maximum is identified by a change from positive to negative slope of the measured signal curve. Another signal curve is then measured with a second value of gain of the amplifier. Measuring of signal curves is repeated until a maximum of a signal curve is detected which is above the predefined level in the linear range of the receiver. The maximum of the measured signal curve with the smallest different to this level is defined as operating point. The value of the gain which is associated with this maximum and the sampling point in time of this maximum both determine the operating point.

It is thereby assured to achieve best results in sensing external objects and at the same time preventing the receiver from entering a saturation range.

In another exemplary embodiment, the recalibration comprises adapting the operating point of the receiver with respect to a changed maximum of the signal received by the receiver.

In yet another embodiment, the recalibration is concluded in continuous mode at predefined points in time.

Recalibration takes place either if the sensing circuit was touched by an external object during initial calibration or/and at regular intervals during continuous mode. In recalibration, the detection of the maximum of the signal received by the receiver as close as possible to the adjustable level of the receiver is repeated and the new values for gain and sampling point in time accorded to this new maximum determine the new operating point. In continuous mode the recalibration serves for adaptation to environmental changes. The recalibration in continuous mode is run through if there is no external object in the proximity.

In another embodiment, during initial calibration a value of the output signal measured at the operating point is defined as bias level. Also during initial calibration the upper threshold is set to a sum of the bias level and a predetermined high offset. The lower threshold is set to a difference of the bias level and a predetermined low offset.

The upper and lower thresholds are used for adjusting the sensitivity of the sensing circuit.

The text below explains the invention in detail using exemplary embodiments with reference to the drawings. Components and circuit elements that are functionally identical or have the identical effect bear identical reference numbers. In so far as circuit parts or components correspond to one another in function, a description of them will not be repeated in each of the following figures. Therein:
Figure 1 shows a first exemplary embodiment of a sensing circuit according to the principle of the invention,
Figure 2 shows a second exemplary embodiment of the sensing circuit according to the principle of the invention,
Figure 3 shows a first use case of the first or second embodiment,
Figure 4 shows a second use case of the first or second embodiment,
Figure 5 shows a third use case in combination with the second embodiment,
Figure 6 shows a fourth use case of the second embodiment,
Figure 7 shows a variant for floating electrode implementation,
Figure 8A to C show different variants for implementation of the capacitors of the or second first embodiment,
Figure 9 shows a third exemplary embodiment of the sensing circuit according to the principle of the invention,
Figure 10A to C show mounting possibilities for floating electrodes,
Figure 11 shows signal diagrams for transmitted and received signals,
Figure 12 shows a signal diagram for the calibration or recalibration of the receiver,
Figure 13A and B show a flowchart of the method for operating the sensing circuit according to the proposed principle, and
Figure 14 shows a flowchart of the FIND_GAIN_TS function of the method according to Figures 13A and 13B.

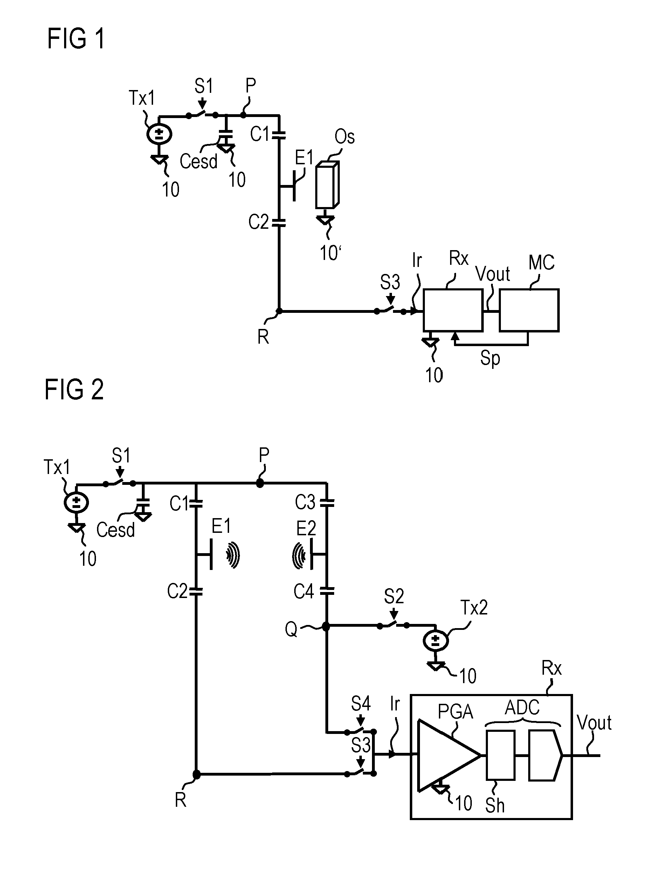

Figure 1 shows a first exemplary embodiment of a sensing circuit according to the principle of the invention. The sensing circuit comprises a serial connection comprising a first capacitor C1 and a second capacitor C2. The second capacitor C2 is coupled in series to the first capacitor C1. The first serial connection is connected between a first node P and a second node R. The sensing circuit further comprises a first transmitter Tx1 and a receiver Rx. The first transmitter Tx1 is on the one side connected to a ground potential 10. On the other side it is connected via a first switch S1 to the first node P. An input of the receiver Rx is coupled to the second node R via a third switch S3. The receiver Rx is also coupled to ground potential 10. At an output of the receiver Rx an output signal Vout is provided and fed to a microcontroller MC. The microcontroller has a control line Sp which is connected to receiver Rx. Control line Sp serves for adjusting parameters of receiver Rx.

The adjacent plates of the first and second capacitors C1, C2 constitute a first floating electrode E1. The first floating electrode E1 is, for instance, realized on a printed circuit board, PCB.

Furthermore, the circuit comprises another capacitor Cesd which is connected to the first node P and to ground potential 10. The other capacitor Cesd represents the node capacitance of first node P. This is also the capacitance which normally is provided to every pin of circuits realized in complementary metal-oxide semiconductor, CMOS, technology for ESD protection.

In operation, first and third switches S1 and S3 are closed by control of the microcontroller MC. The first transmitter Tx1 generates signals which are emitted as electrostatic field via the first capacitor C1 and the first floating electrode E1. If an external object OS approaches the first floating electrode E1, the value of the capacitance at the first floating electrode E1 increases. Consequently, a signal, e.g. a current Ir, at the input of receiver Rx reduces, as well. This is reflected in the output signal Vout which is compared by a comparator in the microcontroller MC to a predefined threshold. As soon as the threshold is passed, the detection of the external object OS is signalled with an interrupt.

In this example, the external object OS is grounded, i.e. the external object OS has an external ground potential 10'.

In this case, only one electrode, namely the first floating electrode E1, is needed to detect the proximity of the external object OS. As only one floating electrode is necessary, the sensitivity of the whole sensing circuit can be improved by increasing the size of this electrode without using up too much space on the surface of a portable device which uses the sensing circuit.

Figure 2 shows a second exemplary embodiment of the sensing circuit according to the inventive principle. The second embodiment corresponds to the first embodiment of Figure 1 except for the additional components described in the following. The sensing circuit according to the second embodiment additionally comprises a second serial connection coupled between the first node P and a third node Q and a second transmitter Tx2. The second serial connection comprises a third and a fourth capacitor C3 and C4 which are connected in series. A second floating electrode E2 is constituted by the adjacent plates of third and fourth capacitors C3 and C4. The second transmitter Tx2 is on the one hand coupled to ground potential 10 and on the side coupled via a second switch S2 to the third node Q. The third node Q is coupled to the input of receiver Rx via a fourth switch S4.

Furthermore, the structure of receiver Rx is shown in detail here. Receiver Rx comprises a gain amplifier PGA and an analog-to-digital converter ADC. An input of the gain amplifier PGA is coupled to the input of the receiver Rx. The gain amplifier PGA is coupled to ground potential 10. An output of the amplifier PGA is coupled to an input of the analog-to-digital converter ADC. The output of the analog-to-digital converter ADC forms the output of the receiver Rx where the output signal Vout is provided. The amplifier PGA is, for instance, a trans-impedance amplifier with programmable gain. The analog-to-digital converter ADC comprises, amongst others, a sample and hold component Sh. The output signal Vout is input to microcontroller MC which is not shown again in this embodiment.

Regarding the dimensioning of the circuit's components, first, second, third and fourth capacitor C1, C2, C3 and C4 are in the range of femtofarad whereas the other capacitor Cesd is in the range of picofarad. The capacitance of the other capacitor Cesd is at least one order of magnitude higher than the capacitance of the first and third capacitor C1 and C3.

Alternatively, the sensing circuit can be realized using only one of first and second transmitters Tx1 and Tx2. This is possible as only one transmitter is used at a time. A transmitter is realized as a signal generator which generates, for instance, a square wave with a frequency of 100 KHz.

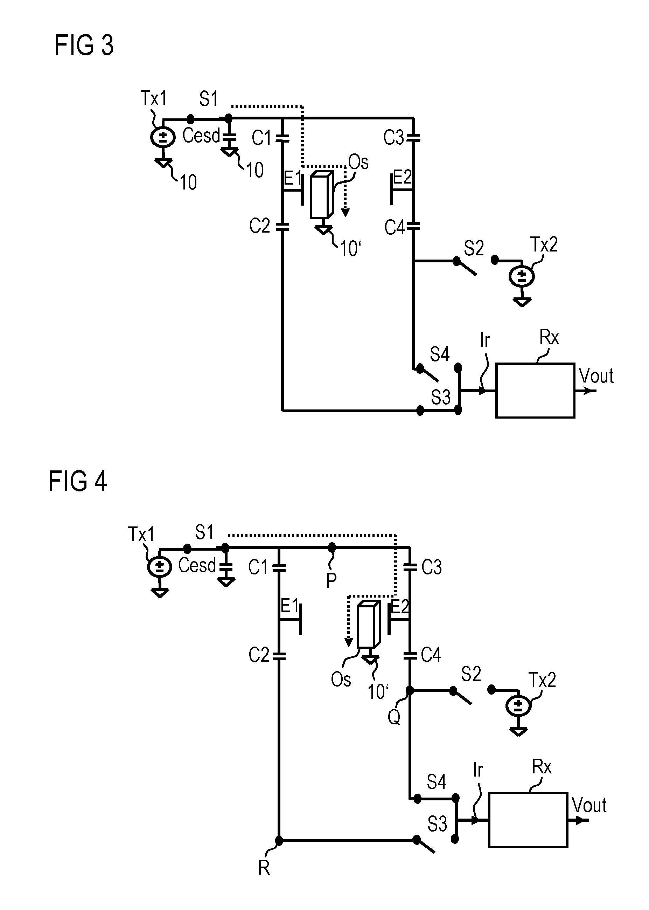

Detailed operation of the sensing circuit is explained below in connection with the different use cases shown in Figures 3 to 6.

Figure 3 shows a first use case of the first or the second embodiment. In this case, an external object Os is detected using just the first floating electrode E1. Therefore, the first or the second embodiment, as of Figures 1 or 2, can be employed for sensing. The external object Os to be sensed is connected to its own external ground potential 10' and is therefore designated as a grounded object. The microcontroller, not shown here, activates the first transmitter Tx1 by closing the first switch S1. The third switch S3 is closed, as well, to build a signal path from the first floating electrode E1 to the receiver Rx.

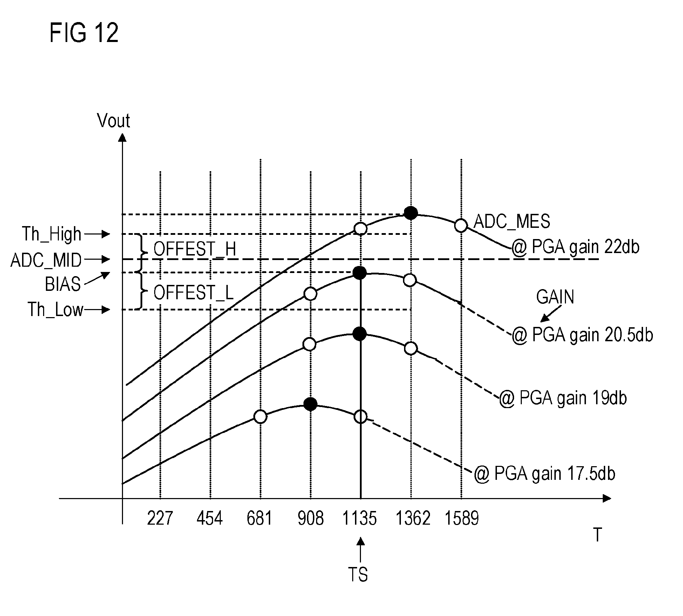

When the external object Os approaches the first electrode E1, a grounded capacitor is formed by the external object Os and the first floating electrode E1. This results in a reduced amplitude of the signal at the input of the receiver Rx. For instance, a receiver current Ir at the input of receiver Rx reduces compared to the current flowing without the external object Os. Consequently, the amplitude of the output signal Vout is reduced as well. In a comparator element which is implemented in the microcontroller MC of Figure 2 the output signal Vout is compared to a threshold. If the threshold is passed by the output signal Vout, a logic signal at the output of the comparator reflects the presence of the external object Os. Determining of the threshold is described in combination with Figure 12.

Figure 4 shows a second use case of the first or second embodiment. Here, the external object Os is sensed using the second floating electrode E2. Once again, the external object Os is connected to external ground potential 10', so that the external object Os is grounded. The microcontroller mC of Figure 2 closes switches S1 and S4.

When the external object Os approaches the second floating electrode E2, the receiver current Ir at the input of receiver Rx is reduced. The resulting output signal Vout is compared in the comparator element to the threshold. The logic signal at the output of the comparator reflects the presence of the external object Os.

By combining the use cases of Figure 3 and Figure 4, two external objects can be detected. To achieve this, the respective logic signals at the output of the comparator have to be combined in a logic AND or in logic OR function depending on the desired use case, that means if the presence of two external objects at the same time shall be detected or if the presence of any external object is to be detected.

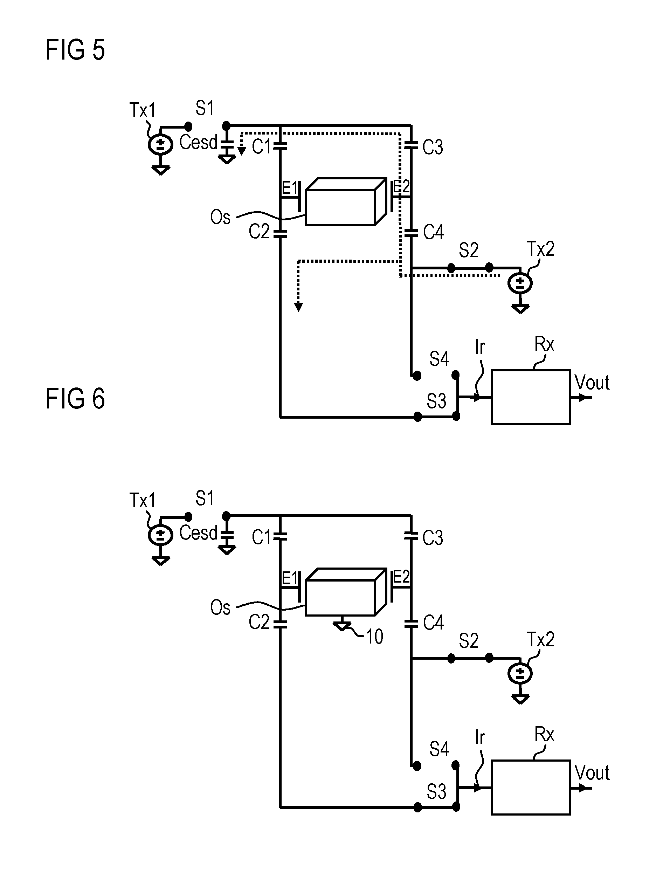

Figure 5 shows a third use case in combination with the second embodiment of the present invention. In this case, the external object Os is an ungrounded object. The microcontroller MC turns on switches S2 and S3. Thus, the second transmitter Tx2 is activated, whereas the first transmitter Tx1 is deactivated. In absence of the external object Os, most of the current generated by the second transmitter Tx2 flows to ground potential 10 via the fourth and third capacitors C4 and C3 and the other capacitor Cesd. Therefore, the receiver current Ir is small.

When the external object Os approaches, a capacitor is built between the first and second floating electrodes E1 and E2. This results in a main flow of current from the second transmitter Tx2 via the fourth capacitor C4, via second and first floating electrodes E2 and E1, via the second capacitor C2 to the input of receiver Rx. The receiver current Ir increases. The resulting output signal Vout is once again compared in the comparator element to a suitable threshold. The logic signal at the output of the comparator element reflects the presence of external object Os.

The described first to third use cases can be used for sensing, for instance, fingers when gripping a mobile phone.

Two fingers touching each side of the phone can be sensed even if they are grounded or ungrounded. For sensing the fingers of a single person touching the mobile phone, the logic AND signal as described under Figure 4 can be used for sensing.

Figure 6 shows a fourth use case for the second embodiment of the sensing circuit. This use case corresponds to the third use case of Figure 5, except that the external object here is connected to external ground potential 10' and is therefore grounded. When this grounded external object Os approaches the first and second floating electrodes E1 and E2, the receiver current Ir is consequently reduced, in contrast to the description of Figure 5. Comparison of the resulting output signal Vout to a suitable threshold in the comparator element generates the logic signal which shows the presence of the external object Os.

In the case that an external object Os, like the hand of a human, is neither perfectly grounded nor perfectly ungrounded but is coupled to ground partially via capacitance caused e.g. by the human's body, thresholds are employed which are lower than the thresholds defined in each of the above use cases.

For sensing all kinds of objects, the microcontroller MC of Figure 1 tries all possible states of switches S1 to S4 according to the use cases described above to detect the presence of an external object.

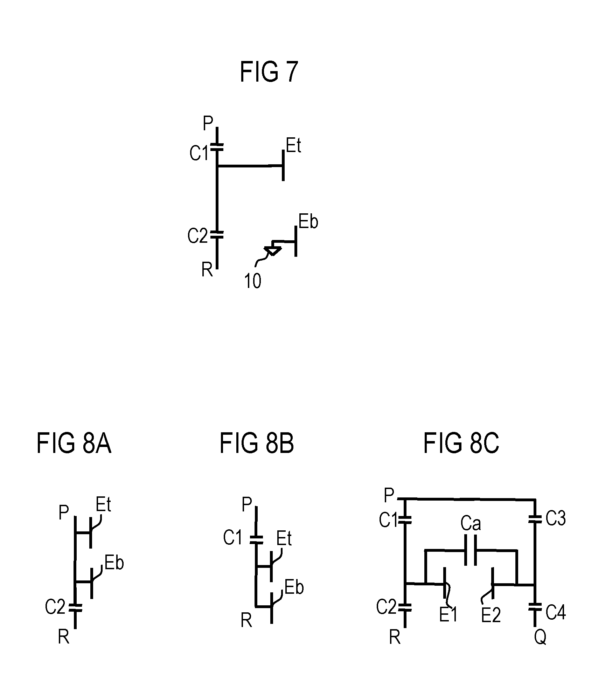

Figure 7 shows a variant floating electrode implementation. The floating electrode is realized as two separate electrodes Et and Eb wherein one of these electrodes is connected to ground potential 10. The ungrounded electrode Et is represents the floating electrode. The described structure of the floating electrode can be used in the case where only one floating electrode is active for sensing. The connection to ground potential 10 in electrode Eb can also be realized as connection to a reference voltage. This implementation is useful for detection of objects which are grounded or ungrounded in the vicinity of two physically close electrodes, i.e. electrodes Et and Eb are both in the vicinity of a single external object. Both electrodes Et and Eb are therefore touched by one finger of a human hand at the same time, for example.

Sensing of partially grounded external objects is thereby improved.

Figures 8A and B each show one variant for implementation of the capacitors of the first embodiment. This means that one of the first or second capacitors C1 and C2 according to Figure 1 can be replaced with a structure of Figure 8A, or B.

In Figure 8A and B one of capacitors C1 and C2 is replaced by two single electrodes Et and Eb.

In Figure 8A, electrode Et is connected to the first node P, electrode Eb is connected to the second capacitor C2.

In Figure 8B, electrode Eb is connected to second node R, electrode Et is coupled to first capacitor C1.

Figure 8C shows an alternative implementation for the second embodiment of the sensing circuit as of Figure 2. An additional capacitor Ca is connected between the floating electrodes E1 and E2. In case the floating electrodes E1 and E2 are implemented apart from each other, i.e. that a single external object like a finger cannot touch both floating electrodes E1 and E2 at the same time, sensing is enhanced by the additional capacitor Ca.

The presented variances lead to a greater flexibility in designing a sensing circuit according to the proposed principle.

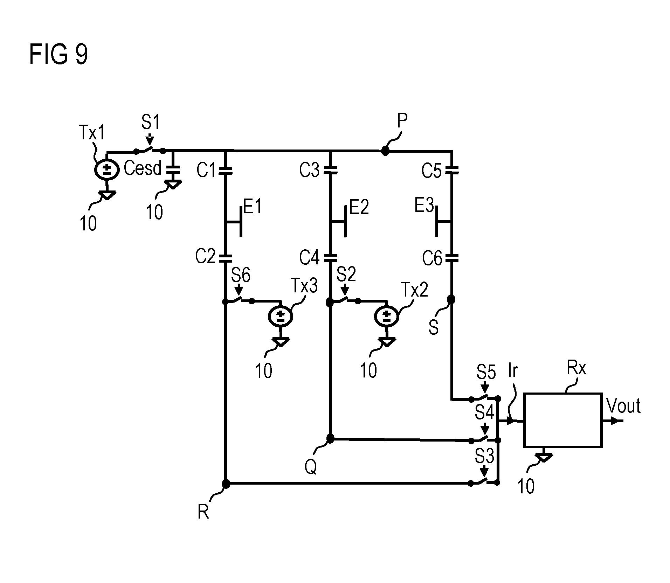

Figure 9 shows a third embodiment of the sensing circuit according to the principle of the invention. The sensing circuit corresponds to the sensing circuit of the second embodiment as described in Figure 2, except for an additional third serial connection and a third transmitter Tx3. The third serial connection is coupled between the first node P and a fourth node S. The third serial connection comprises a fifth and sixth capacitor C5 and C6 which are connected in series. The adjacent plates of the fifth and sixth capacitor C5 and C6 constitute a third floating electrode E3. Fourth node S is coupled via switch S5 to the input of receiver Rx. The third transmitter Tx3 is, on the one hand, coupled to ground potential 10 and, on the other hand, coupled via switch S6 to the third node R. The third embodiment equally comprises microcontroller MC which is not repeated here.

The operation of this embodiment of the sensing circuit resembles the operation of the second embodiment described under Figure 2. The third floating electrode E3 is disabled by opening switch S2. The third transmitter Tx3 is disabled by opening the first switch S1. In this case, node R acts as receiver only. Node Q acts as receiver or transmitter. With this configuration the same operation as described in the second embodiment is achieved.

Furthermore, the third embodiment can be used for a so-called three sense object operation with first and second floating electrodes E1 and E2 configured as transmitter and the third floating electrode E3 configured as receiver. Either first or second floating electrodes E1 and E2 or both of them can be set as transmitters. Thereby, external objects can be detected which are near the first and the third floating electrode E1 and E3 or which are near the second and the third electrode E2 and E3 or which are near the first, the second and the third floating electrode E1, E2 and E3. In each case, the threshold which is used in the comparator is determined in advance to match the output signal Vout in the respective case.

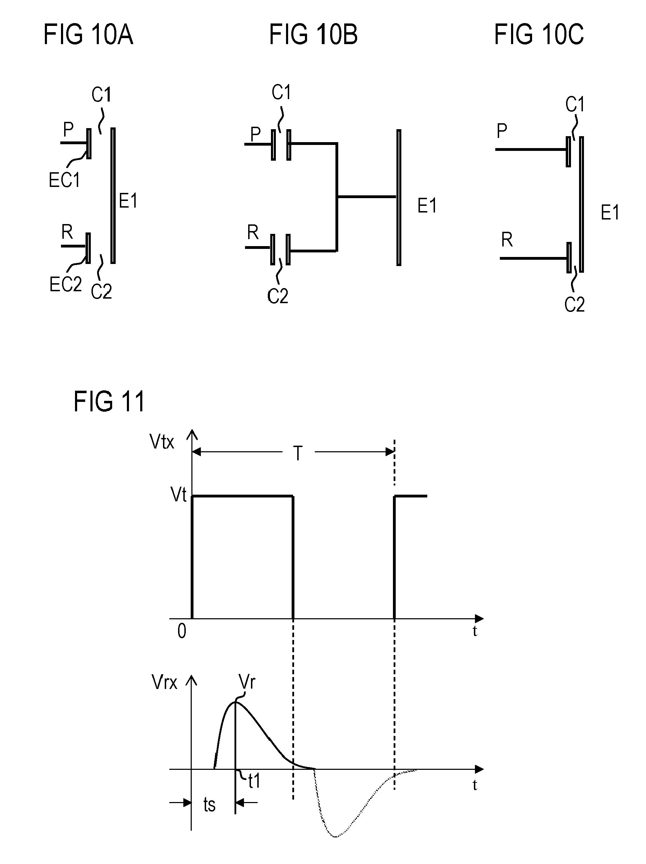

Figure 10A to 10C show mounting possibilities for floating electrodes. These are to be used in combination with the embodiments described above. Figure 10A shows a so-called contactless solution. The first floating electrode E1 is realized on PCB without wired contact to the remaining components of the sensing circuit. The second electrodes of first and second capacitors C1 and C2 are formed also on PCB. The upper electrode EC1 which is the second electrode of the first capacitor C1 is connected to the first node P. The lower electrode EC2 which is the second electrode of the second capacitor C2 is connected to node R. Thus, the capacitors C1 and C2 are composed in the air gap between the electrodes EC1 and E1 and EC2 and E1, respectively, as shown.

As an advantage, no wired connection has to be established between the sensing electrode, which is one of the floating electrodes of the described sensing circuits, to the remaining components of the circuit. This greatly enhances the flexibility in positioning the floating electrodes on the surface of a portable device.

Figure 10B shows a so-called single contact solution. The floating electrode E1, as well as, first and second capacitors C1 and C2, are realized on PCB. Just one single solder point exists between the floating electrode E1 and the capacitors C1 and C2.

Figure 10C shows a so-called two-contact solution. Two solder points are used to connect the second electrodes of capacitors C1 and C2 to the first node P or the second node R.

Following the concept of the floating electrode, a number of different mounting possibilities is advantageously offered.

Figure 11 shows signal diagrams with transmitted and received signals. The diagrams apply to all embodiments described above. The upper diagram shows the transmitted signal Vtx which is generated e.g. by the first transmitter Tx1 from Figure 1 in relation to time t. The second diagram shows the received signal Vrx at the output of amplifier PGA e.g. of Figure 1 in relation to time t. The transmitted signal Vtx is for instance a rectangular signal as shown with amplitude Vt and a time period T. The received signal Vrx comprises a peak amplitude Vr at a point in time t1. Obviously, a time delay ts occurs between the start of Vt of the transmitted signal Vtx and the peak amplitude Vr of the received signal Vrx. Furthermore, due to and depending upon environmental changes, for example changes in temperature, due to physical parameters, the peak amplitudes Vt and Vr have different values. So the gain from Vt to Vr changes. There also appears a change in phase between the transmitted signal Vtx and the received signal Vrx.

Figure 12 shows a signal diagram for the calibration or recalibration of the receiver. This diagram applies to receivers Rx of all embodiments described above. On the x-axis the sampling time T is shown. The y-axis depicts the output signal Vout. Different curves A1, A2, A3 and A4 are presented. For each curve A1 to A4 a different value of gain is used in the amplifier of the receiver. In each curve the peak value or maximum marked with a black dot is determined. A dotted line named ADC_MID marks an adjustable level within the linear range of the receiver, especially within the linear range of the analog-to-digital converter of the receiver. A second dotted line named BIAS marks the value of the output signal Vout at the defined operating point of the receiver Rx.

Dotted lines named Th_High and Th_Low represent the upper and lower thresholds used during continuous mode of operating the sensing circuit. The difference between the upper threshold Th_High and bias level BIAS is the high offset OFFSET_H. The difference between the bias level BIAS and the lower threshold Th_Low is the low offset OFFSET_L.

GAIN signifies the value of gain used in the amplifier at the determined operating point. TS signifies the sampling poit in time used in the analog-to-digital converter at the determined operating point. ADC_MS represents a measured value of the output signal Vout.

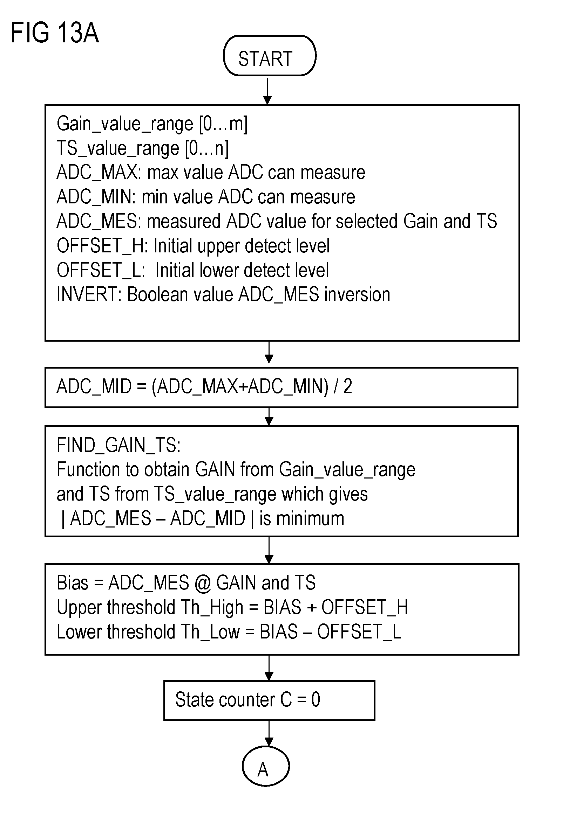

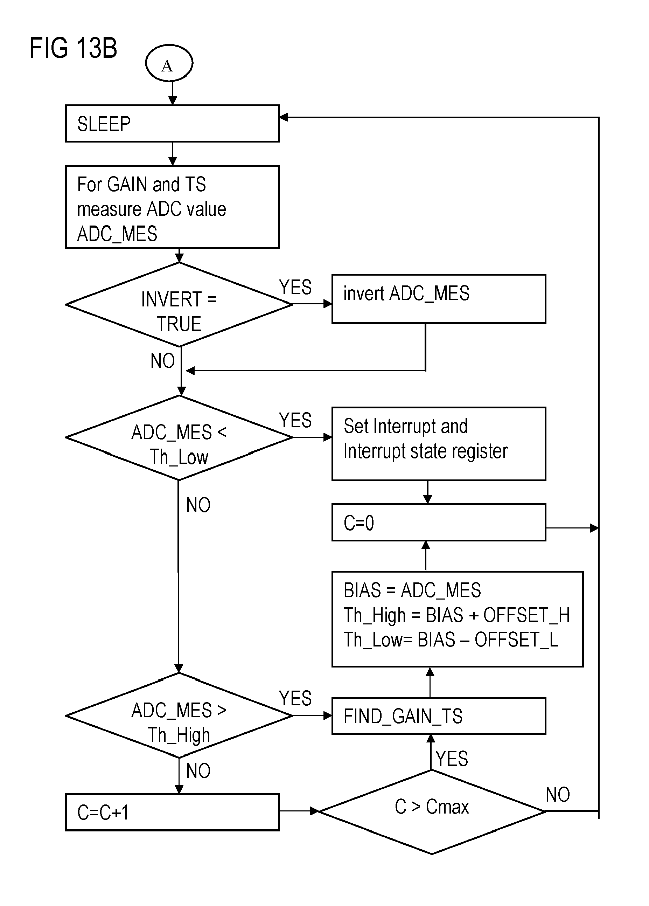

The signal diagram is explained in more detail in combination with the flowchart of the method of Figures 13A and B.

Figures 13A and B show a flowchart of the method for operating the sensing circuit according to the proposed principle. The flowchart applies to all embodiments of the sensing circuit described above.

In the beginning, different parameters are set to an initial value. Gain_value_range corresponds to the different values of gain which can be programmed on the programmable gain amplifier of receiver Rx. TS_value_range corresponds to the time shift values which can be applied to the analog-to-digital converter ADC of receiver Rx. As ADC_MAX and ADC_MIN are the maximum and minimum measurable values of the analog-to-digital converter ADC, the level of the future operating point is adjusted to ADC_MID which in this example is in the middle between ADC_MAX and ADC_MIN. INVERT refers to a Boolean value which reflects whether the output of the receiver is to be inverted or not. In case the proximity or touch of an external object increases the receiver output which is true e.g. for the second embodiment described in Figure 2, the method inverts the receiver output around the bias level. It is thereby ensured that the value ADC_MES during proximity or touch detection is always below the lower threshold.

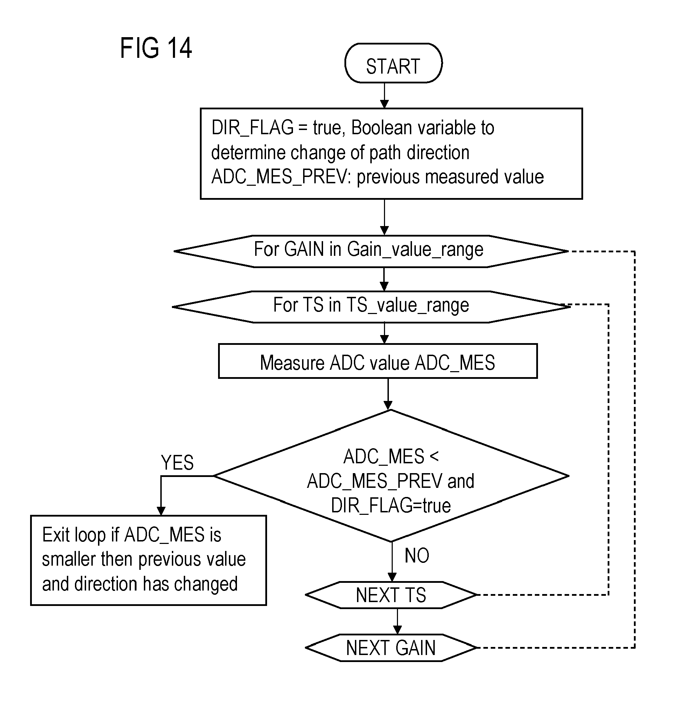

In the function FIND_GAIN_TS which is used during calibration and recalibration steps of the method, a value for the gain and a value for the time shift are each determined. The steps to be completed are described in combination with Figure 14 below.

Next, the absolute difference of the measured peak values and ADC_MID level is calculated. The peak value with the minimum absolute difference to ADC_MID level is defined as operating point. The corresponding value of the output signal Vout is defined as bias level BIAS. In addition, an upper threshold Th_High is set to a sum of bias level BIAS and the predetermined high offset OFFSET_H. A lower threshold Th_Low is set to a difference of the bias level BIAS and the predetermined low offset OFFSET_L. A state counter C is set to zero.

The method continues at point A in Figure 13B where it enters continuous mode of operation.

After some pause in the step Sleep, a value ADC_MES is measured in the output signal Vout with the receiver being configured to the determined operating point. The measured value ADC_MES is compared, directly or in case the INVERT value is true in an inverted form, in the comparator element to the lower threshold Th_Low. If the measured value ADC_MES is lower than the lower threshold Th_Low, the presence of an external object is detected. Therefore, an interrupt is generated and the interrupt state register is set. State counter C is reset to zero. The method continues at point A in the continuous mode.

In the other case, where the measured value ADC_MES is higher than the lower threshold Th_Low, the measured value ADC_MES is compared to the upper threshold Th_High. If the measured value ADC_MES is lower than the upper threshold Th_High no external object has occurred at the sensing circuit. Consequently, state counter C is incremented by one. As long as state counter C is smaller than a maximum state counter Cmax, the method continues in the continuous mode.

In case that the maximum state counter Cmax is reached or in case that the measured value ADC_MES is higher than the upper threshold Th_High, a recalibration is performed by completing once again the function FIND_GAIN_TS. A measured value ADC_MES of the output signal Vout which is higher than the upper threshold Th_High signifies that during initial calibration when previously running FIND_GAIN_TS function the sensor was calibrated in the presence of an external object. For correct operation of the sensing circuit, the receiver has to be recalibrated. This recalibration determines a new operating point resulting in a new bias level BIAS according to a newly determined peak value of the output signal Vout. The upper and lower thresholds Th_High and Th_Low are adapted accordingly. The method continues in the continuous mode

As an advantage, the method enables automatic gain control and dynamic time shift control of the receiver. In addition, an automatic synchronization of transmitted and received signals is achieved. The receiver amplitude is synchronized to a peak value with respect to the transmitted signal phase. The automatic calibration as described above is concluded without any dependence on the presence or absence of an external object. The proposed method is completely tolerant to variations in chip gain, air gaps, temperature and metal surfaces in the capacitive sensor. In a very general way, the method can be applied to other sensor systems, not only capacitive sensor systems, these other systems being based on a transmitter-receiver concept. Cracks in the printed electrodes realized on PCB do not influence the method.

Upper and lower offsets OFFSET_H and OFFSET_L are employed to adjust the sensitivity of the sensing circuit. Thereby, the different use cases for grounded, ungrounded or partially grounded objects as described above are taken into account.

Figure 14 shows a flowchart of the FIND_GAIN_TS function of the method according to Figures 13A and 13B. For each value of gain the peak value of the output signal Vout is determined by changing the value of the sampling point on the sampling time T as of Figure 12. The peak value is marked by a change of slope from positive to negative in the output signal Vout. This change of slope is tracked with Boolean variable DIR_FLAG. Adaptation of gain value and sampling point value is repeated until a peak value or maximum is found which is above the predefined ADC_MID level. For each curve A1 to A4 of figure 12, measuring stops as soon as a peak amplitude value is found.

### Reference list

- C1, C2, ...., C6: Capacitor
- Cesd, Ca: Capacitor
- E1, E2, E3: electrode
- Et, Eb: electrode
- P, Q, R, S: Node
- Tx1, Tx2, Tx3: Transmitter
- Rx: Receiver
- S1*,* S2, ..., S6: switch
- PGA: amplifier
- ADC: analog-to-digital converter
- Vout: output signal
- Th_Low, Th_High: threshold
- BIAS: bias level
- OFFSET_H, OFFSET_L: offset
- 10, 10': ground potential
- Sh: sample-and-hold
- Sp: sampling point signal
- MC: Microcontroller
- Os: external object
- ADC_MID: level
- ADC_MES: measured value
- A1, A2, A3, A4: curve
- C: Counter
- Ir: signal
- Vrx, Vtx: signal
- T1: point in time
- GAIN, TS: value
- T, t: time

## Claims

1. Sensing circuit comprising
- a first serial circuit comprising a first and a second capacitor (C1, C2) connected in series, the first serial circuit being connected between a first node (P) and a second node (R),
- a first transmitter (Tx1) which is coupled to the first node (P) in a switchable manner,
- a receiver (Rx) which is coupled to the second node (R) in a switchable manner,
wherein a first floating electrode (E1) is constituted by the adjacent plates of first and second capacitor (C1, C2), wherein the first floating electrode (E1) is adapted to emit an electric field by means of the first transmitter (Tx1) and to detect a change in capacitance in the emitted electric field caused by an external object, and
wherein the receiver (Rx) is adapted to provide an output signal (Vout) as a function of the change in capacitance at the first floating electrode (E1).

2. Sensing circuit according to claim 1,
further comprising
- a second serial circuit comprising a third and a fourth capacitor (C3, C4) connected in series, the second serial circuit being connected between the first node (P) and a third node (Q), wherein the third node (Q) is coupled to the receiver (Rx) in a switchable manner,
- a second transmitter (Tx2) which is coupled to the third node (Q) in a switchable manner,
- another capacitor (Cesd) which is coupled to the first node (P) and is connected to ground potential (10), wherein a second floating electrode (E2) is constituted by the adjacent plates of third and fourth capacitor (C3, C4), wherein the second floating electrode (E2) is adapted to emit an electric field by means of the first or second transmitter (Tx1, Tx2) and to detect a change in capacitance in the emitted electric field caused by an external object, and
wherein the receiver (Rx) is adapted to provide the output signal (Vout) as a function of the change in capacitance at the second floating electrode (E2) or as a function of the change in capacitance between the first and second floating electrode (E1, E2).

3. Sensing circuit according to claim 2,
further comprising
- a third serial circuit comprising a fifth and a sixth capacitor (C5, C6) connected in series, the third serial circuit being connected between the first node (P) and a fourth node (S), wherein fourth node (S) is coupled to the receiver (Rx) in a switchable manner,
- a third transmitter (Tx3) which is coupled to the second node (R) in a switchable manner,
wherein a third floating electrode (E3) is constituted by the adjacent plates of fifth and sixth capacitor (C5, C6), wherein the third floating electrode (E3) is adapted to emit an electric field by means of the first, second or third transmitter (Tx1, Tx2, Tx3) and to detect a change in capacitance in the emitted electric field caused by an external object, and
wherein the receiver (Rx) is adapted to provide the output signal (Vout) as a function of the change in capacitance at the third floating electrode (E3) or as a function of the change in capacitance between the first and third floating electrodes (E1, E3) or between the second and third floating electrodes (E2, E3).

4. Sensing circuit according to claim 3,
wherein the first and / or second and / or third floating electrodes (E1, E2, E3) is / are each implemented on a Printed Circuit Board without wired contact to the remaining sensing circuit.

5. Sensing circuit according to claim 3,
wherein the first and / or second and / or third floating electrodes (E1, E2, E3) is / are each implemented on a Printed Circuit Board with a single wire contact to the remaining sensing circuit.

6. Sensing circuit according to claim 3,
wherein the first and / or second and / or third floating electrodes (E1, E2, E3) is / are each implemented on a Printed Circuit Board with a double wire contact to the remaining sensing circuit.

7. Sensing circuit according to one of claims 3 to 6, wherein the receiver (Rx) comprises
- an amplifier (PGA) which is adapted to receive a signal (Ir) from at least one of first, second or third floating electrodes (E1, E2, E3), and
- an analog-to-digital converter (ADC) coupled to an output of the amplifier (PGA), the analog-to-digital converter (ADC) being adapted to provide the output signal (Vout).

8. Sensing circuit according to one of claims 3 to 7,
wherein one or more of first, second, third, fourth, fifth or sixth capacitors (C1, C2, C3, C4, C5, C6) are realized as two separate electrodes (Et, Eb).

9. Sensing circuit according to one of claims 3 to 7,
wherein one or more of first, second, third, fourth, fifth or sixth capacitors (C1, C2, C3, C4, C5, C6) are realized as two separate electrodes (Et, Eb) wherein one of these electrodes is coupled to ground potential (10).

10. Sensing circuit according to one of claims 1 to 9, further comprising a comparator element which is connected to the output of the receiver (Rx) and which is adapted to indicate whether a value of the output signal (Vout) is below a lower threshold (Th_Low) or above an upper threshold (Th_High).

11. Method for operating a sensing circuit comprising the following steps:
- performing an initial calibration with identification of an operating point in the linear range of a receiver (Rx) of the sensing circuit,
- operating in continuous mode, comprising
- measuring a value (ADC_MES) of an output signal (Vout) of the receiver (Rx) at the identified operating point in programmable time intervals,
- if the value is below a lower threshold (Th Low): generating an interrupt and then continuing with the continuous operation,
- if the value is above an upper threshold (Th_High): running through a re-calibration and then continuing with the continuous operation.

12. Method according to claim 11,
wherein
- the operating point of the receiver (Rx) is defined by a value (GAIN) of a gain of its amplifier (PGA) and a respective sampling point (TS) in time of its analog-to-digital converter (ADC) at a maximum of a signal (Ir) received by the receiver (Rx), the maximum being related to a transmitted signal phase,
- the operating point of the receiver (Rx) is determined during calibration or re-calibration such that a value of the output signal (Vout) output from the receiver (Rx) at the operating point is as close as possible to a predetermined level (ADC_MID) within the linear range of the receiver (Rx).

13. Method according to the previous claim,
wherein the re-calibration comprises adapting the operating point of the receiver (Rx) with respect to a changed maximum of the signal (Ir) received by the receiver (Rx).

14. Method according to one of claims 11 to 13,
wherein the re-calibration is concluded in continuous mode at predefined points in time.

15. Method according to one of claims 11 to 14,
wherein
- during initial calibration a value of the output signal (Vout) measured at the operating point is defined as bias level (BIAS), and
- during initial calibration the upper threshold (Th_High) is set to a sum of the bias level (BIAS) and a predetermined high offset (OFFSET_H) and the lower threshold (Th_Low) is set to a difference of the bias level (BIAS) and a predetermined low offset (OFFSET_L).
